(19)

**Europäisches Patentamt**
**European Patent Office**
**Office européen des brevets**

(11) **EP 3 581 993 A1**

(12) **EUROPEAN PATENT APPLICATION**

(43) Date of publication:
**18.12.2019 Bulletin 2019/51**

(51) Int Cl.:
**G02F 1/025** (2006.01)  **G02F 1/015** (2006.01)

(21) Application number: **18176934.0**

(22) Date of filing: **11.06.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **IMEC vzw**
  **3001 Leuven (BE)**
• **Katholieke Universiteit Leuven**
  **KU Leuven Research & Development**
  **3000 Leuven (BE)**

(72) Inventors:
• **KIM, Mr., Sanghyeon**
  **3001 Leuven (BE)**
• **BAN, Ms., Yoojin**
  **3001 Leuven (BE)**
• **VAN CAMPENHOUT, Mr., Joris**
  **3001 Leuven (BE)**
• **PANTOUVAKI, Ms., Maria Ioanna**
  **3001 Leuven (BE)**

(74) Representative: **Roth, Sebastian**
**Mitscherlich PartmbB**
**Patent- und Rechtsanwälte**
**Sonnenstraße 33**
**80331 München (DE)**

(54) **MONOLITHIC III-V/SI WAVEGUIDE PHASE MODULATOR**

(57)    The present invention provides a monolithic integrated, waveguide carrier depletion phase modulator, specifically of the III-V/Si-based heterogeneous type. The modulator includes a monolithically integrated III-V/Si p-n junction diode, in order to modulate the phase of light, which propagates through a waveguide of the modulator. The waveguide includes a waveguide base made of a first conductivity type Si-based semiconductor material, at least one groove formed in a surface of the waveguide base, and an epitaxial region formed on the waveguide base in the groove. The epitaxial region 13 is made of a second conductivity type III-V semiconductor material. The monolithically integrated junction diode is formed by the waveguide base and the epitaxial region

FIG. 1

EP 3 581 993 A1

**Description**

TECHNICAL FIELD

The present invention relates to the technical field of optical modulators. The present invention presents in particular a monolithic integrated waveguide phase modulator, and specifically a hybrid III-V/Si carrier depletion phase modulator. The monolithic integrated phase modulator of the present invention includes at least one monolithically integrated III-V/Si junction diode, which defines at least one phase modulation region of the modulator.

BACKGROUND OF THE INVENTION

An optical modulator is an essential optical building block, for instance, in Si photonics. An optical modulator is generally used to modulate the phase and/or intensity of light, for example, as propagated through a waveguide of the optical modulator. A typical Si-based optical modulator uses the free-carrier plasma dispersion effect, in order to achieve the phase modulation of the light by changing a carrier density in the waveguide.

The efficiency of such a Si-based optical modulator is, however, inherently limited by the effective mass and mobility of free carriers in Si, since the amount of phase modulation is inversely proportional to the effective mass and the amount of intensity modulation inversely proportional to the effective mass and mobility. This can be seen in the following formulas, which respectively describe the plasma dispersion effect (i.e. a change $\Delta n$ of the refractive index n with change of carrier density) and the free carrier absorption (i.e. a change $\Delta \alpha$ of the absorption coefficient $\alpha$ with a change of carrier density). The change of the carrier density particularly includes a change $\Delta N_e$ and a change $\Delta N_h$ of the electron density $N_e$ and hole density $N_h$, respectively.

$$\Delta n = -\frac{e^2 \lambda^2}{8\pi^2 c^2 \varepsilon_0 n}\left(\frac{\Delta N_e}{m_{ce}^*} + \frac{\Delta N_h}{m_{ch}^*}\right)$$

$$\Delta \alpha = -\frac{e^3 \lambda^2}{4\pi^2 c^3 \varepsilon_0 n}\left(\frac{\Delta N_e}{m_{ce}^{*2}\mu_e} + \frac{\Delta N_h}{m_{ch}^{*2}\mu_h}\right)$$

In the above formulas, $m_{ce}^*$ is the effective electron mass, $m_{ch}^*$ is the effective hole mass, $\mu_e$ is the electron mobility, and $\mu_h$ is the hole mobility. It can be easily appreciated that the refractive index n increases when the effective carrier masses $m_{ce}^*$ and $m_{ch}^*$ decrease, and that it decreases when the effective carrier masses increase. Likewise, the absorption coefficient $\alpha$ increases when the effective carrier masses $m_{ce}^*$ and $m_{ch}^*$ decrease, and it decreases when the effective carrier masses increase. However, the absorption coefficient also increases when the carrier mobilities $\mu_e$ and $\mu_h$ decrease, but decreases when the carrier mobilities increase.

Due to the above effects, some efforts have been devoted to the use of III-V materials, in order to utilize their lower effective mass and higher carrier mobility (compared to Si-based materials). However, all so far reported III-V/Si hybrid modulators rely on a wafer bonding process, which is not well-suited for high-volume manufacturing.

SUMMARY OF THE INVENTION

In view of the above-mentioned challenges, the present invention aims to improve the Si-based optical modulators, and particularly III-V/Si hybrid modulators reported so far. The present invention has accordingly the objective to provide a Si-based optical modulator with a higher modulation efficiency, wherein the modulator is also better suited for high-volume manufacturing. The present invention also aims for a production method for such an optical modulator, which can be well integrated into high-volume processing. The optical modulator of the present invention should further be able to operate with higher phase modulation efficiency and lower optical loss of the modulated light, compared to conventional modulators.

The objective of the present invention is solved by the subject matter provided in the enclosed independent claims. Advantageous implementations of the present invention are further defined in the dependent claims.

In particular the present invention presents a highly manufacturable high-efficiency, waveguide based, monolithic III-V/Si carrier depletion diode phase modulator. This new kind of modulator may be realized by implementing a region of III-V semiconductor material on a Si-based waveguide base by using for example epitaxial growth, and preferably by applying selective area growth (SAG) processing techniques.

A first aspect of the present invention is directed to a monolithic integrated phase modulator comprising a waveguide for propagating light, wherein the waveguide includes: a waveguide base made of a first conductivity type Si-based semiconductor material, at least one groove formed in a surface of the waveguide base, an epitaxial region formed on the waveguide base in the groove, wherein the epitaxial region is made of a second conductivity type III-V semiconductor material; and wherein the waveguide base and the epitaxial region form a monolithically integrated junction diode that is a phase modulation region for the light propagated through the waveguide.

The first conductivity type may be p-type, and the second conductivity type may be n-type. However, also the opposite conductivity types are respectively possible. The waveguide base may particularly be made of Si and/or SiGe, and may be doped for p-type with e.g. B, Al or Ga, and for n-type with e.g. P, As or Sb.

The groove may be formed continuously along the waveguide direction. It can thereby extend along a part of the waveguide base or along the entire waveguide base. The extension of the groove may be straight, and may be parallel to the light propagation direction of the waveguide.

The at least one epitaxial region (e.g. exactly one epitaxial region in case of one groove) may be a crystalline layer or film, which may be grown (deposited) epitaxially on the waveguide base in the groove. For instance, the epitaxial region may be grown by molecular beam epitaxy (MBE), vapor-phase epitaxy (VPE), or other suitable epitaxy techniques. The epitaxial region may be doped during its growth, i.e. the second conductivity type of the epitaxial region can be set and controlled during growth.

Notably, for the modulator of the first aspect and all implementations thereof, the III-V semiconductor material of the at least one epitaxial region may include at least one of InP, GaAs, InGaAs and InGaAsP. If the second conductivity type of the III-V semiconductor material is n-type, the material may be doped with e.g. Si, Ge, Se or Te. If the second conductivity type of the III-V semiconductor material is p-type, the material can be doped with e.g. C, Be, or Zn.

Each epitaxial region of the modulator may comprise a uniform or non-uniform III-V material stack. The III-V semiconductor material of an epitaxial region may at least partly fill a groove, preferably may fill the groove completely, i.e. up to the upper surface of the waveguide base. However, the III-V semiconductor material of an epitaxial region can in principle also grow partially outside the waveguide base, i.e. may reach above the upper surface of the waveguide base.

The junction diode is a phase modulation region, as in operation of the monolithically integrated phase modulator, light that is propagated through the waveguide may be phase modulated by reversely biasing the junction diode. This reverse bias modulates the phase of the propagated light based on the reverse bias potential. This is, because reversely biasing the junction diode creates a depletion region in the waveguide base and the epitaxial region, respectively, i.e. it reduces both electron density and hole density. Accordingly, a refractive index and absorption coefficient change, thus leading to a phase shift of the propagated light.

The fact that the epitaxial region is made of III-V semiconductor material, enhances significantly the modulation efficiency of the modulator of the invention, because the effective carrier masses are significantly lower than for Si-based semiconductor materials. Thus, the refractive index change is more pronounced with a change of the carrier densities. Moreover, a high-quality III-V epitaxial region can be grown on the waveguide base in the groove. The high quality of the epitaxial region leads to a high carrier mobility, which further enhances the performance of the modulator. In particular, the absorption coefficient is absolutely lower than for Si-based materials, which reduces optical loss.

In an implementation of the monolithic integrated phase modulator, the waveguide includes: a plurality of grooves formed in the surface of the waveguide base and arranged one after the other along a light propagation direction of the waveguide, and a plurality of epitaxial regions made each of a second conductivity type III-V semiconductor material, wherein an epitaxial region is formed on the waveguide base in each of the grooves; wherein the waveguide base and each of the epitaxial regions form the monolithically integrated junction diode.

The grooves may all be identical, but may also vary in shape. For instance, a plurality of U-grooves or V-grooves (e.g. "inverted" pyramids) can be formed along the waveguide direction. Preferably, the plurality of grooves are thereby arranged behind each other along (in-line with) the light propagation direction of the waveguide. Further, each groove can extend straight and parallel to said propagation direction. Each groove can span the entire width of the waveguide, or at least the largest part of the waveguide width.

The epitaxial regions may all be formed at the same time, thus, they may be made of the same III-V semiconductor material and/or may have the same doping level and/or profile. However, it is also possible to use different III-V semiconductor materials and/or doping levels and/or profiles for creating different epitaxial layers in different grooves.

The integrated junction diode may in this implementation include the waveguide base and each of the epitaxial regions. However, each epitaxial region together with the waveguide base may also be considered to be an individual monolithically integrated junction diode, so that the modulator comprises multiple integrated junction diodes. These junction diodes could be biased collectively or individually, in order to control the phase modulation of the light propagating through the waveguide.

In another implementation of the monolithic integrated phase modulator, each epitaxial region together with the waveguide base is a separate phase modulation region for the light propagated through the waveguide.

Each phase modulation region may, in operation of the modulator, provide a modulation of the phase of the light propagated through the waveguide. Thereby, the phase modulations could be individually controlled. The multiple phase modulation regions provide the modulator with an even higher modulation efficiency and also more modulation flexibility.

In another implementation of the monolithic integrated phase modulator, adjacent grooves are distanced by a subwavelength pitch.

Subwavelength pitch means that the pitch, i.e. a distance between adjacent grooves (e.g. measured from center to center of their longitudinal extensions along the waveguide), is smaller (shorter) than a wavelength of the light propagated through the waveguide. For instance, the pitch may be 90% of the wavelength or less, 75% of the wavelength or less, or even 50% of the wavelength or less. Apart from the subwavelength nature of the pitch, the pitch is an optimizing parameter for the modulator and can be adjusted to tune its performance for different wavelengths and III-V materials.

In another implementation of the monolithic phase modulator, each epitaxial region is arranged to guide at least a part of light that is propagated in the waveguide.

Preferably, each epitaxial region is even arranged to guide most or substantially all of the light propagated in the waveguide. That is, most of the light propagated in the waveguide may be confined in the epitaxial layer. Since a depletion region under reverse bias of the junction diode establishes first and strongest in the epitaxial region, the modulation efficiency of the modulator is highest in this case. This may be achieved by designing the shape and size of the at least one groove, particularly arranging its sidewalls within the crystal structure of the Si-based waveguide base, e.g. along crystal facets.

In another implementation, the monolithic integrated phase modulator further comprises a first lead electrically contacting the waveguide base, wherein the first lead is made of a first conductivity type Si-based semiconductor material, and a second lead electrically contacting each epitaxial region, wherein the second lead is made of a second conductivity type Si-based semiconductor material.

In particular, the first lead may contact the waveguide base laterally, i.e. from the side and perpendicularly to the light propagation direction through the waveguide. The second lead may preferably contact the epitaxial region also laterally and/or from the top. Through a reverse potential applied across the two leads, at least one junction diode of the modulator can be reversely biased, which again leads to a phase modulation of the light propagating through the waveguide during operation of the modulator.

In another implementation of the monolithic integrated phase modulator, the second lead includes a sidewall region of the waveguide that electrically contacts each epitaxial region, and the sidewall region of the waveguide of the second lead is of the second conductivity type.

In particular, the sidewall region is a part of the waveguide, wherein the waveguide further comprises the waveguide base and the at least one epitaxial layer. With the second lead comprising the sidewall region laterally contacting the epitaxial region, preferably at the upper surface of the epitaxial layer, advantageously a top connection outside of the waveguide to the at least one epitaxial region can be avoided. Thus, optical losses of the light propagating through the waveguide, which are caused by top contacts, can be eliminated.

In another implementation of the monolithic integrated phase modulator, each epitaxial region and the waveguide base are arranged to be depleted, when the junction diode is reversely biased by applying a reverse potential across the leads.

In this case, the refractive index changes in the waveguide base and the at least one epitaxial region, respectively. However, it changes more pronounced in the epitaxial region. As a consequence, light that propagates through the waveguide experiences a phase modulation in the depletion regions. Thus, light propagating through the waveguide can be phase modulated. Since most of the light is preferably confined in the epitaxial region(s), the modulation efficiency is high.

In another implementation of the monolithic integrated phase modulator the at least one groove is a V-groove or U-groove.

A V-groove is a grove having a V-shape in at least one cross-sectional view, possibly even in two perpendicular cross-sectional views. A U-groove is a grove having a U-shape in at least one cross-sectional view, possibly even in two perpendicular cross-sectional views. With a V-groove or U-groove, a confinement of most light propagating through the waveguide in the epitaxial region can be achieved.

In another implementation of the monolithic integrated phase modulator at least one sidewall of the at least one groove is arranged along a (111)-facet of the Si-based waveguide base.

For instance, the at least one groove may be formed in a V-shape following the (111) surfaces of the waveguide base. This leads to a stronger confinement of the light propagating though the waveguide within the epitaxial region(s). Further, the growth of the at least one epitaxial region can be carried out with higher quality, thus increasing carrier mobilities and reducing losses. Further, defects are mostly located at the interface, which is narrow and as such they do not influence too much the light propagating through the waveguide in operation of the modulator.

The epitaxial region may, depending on the shape of the groove, be a planar epitaxial layer or preferably a non-planar epitaxial layer. A planar layer has a surface within a single plane, while a surface of a non-planar layer is at least within two planes.

In another implementation of the monolithic integrated phase modulator, the second conductivity type epitaxial region has a doping level between $1 \cdot 10^{16}$ cm-3 and $5 \cdot 10^{18}$ cm-3, and/or the first conductivity type Si-based semiconductor material has a doping level between $1 \cdot 10^{17}$ cm-3 and $1 \cdot 10^{19}$ cm-3, and/or, when the modulator comprises a second conductivity type sidewall region of the waveguide, the second conductivity type sidewall region has a doping level between $1\cdot10^{17}$ cm-3 and $1\cdot10^{19}$ cm-3.

The above doping level of the epitaxial region allows efficiently creating depletion regions by reversely biasing the junction diode, while there is little or no depletion at zero bias. This allows efficiently modulating the phase of the light. The above doping level of the leads and the sidewall region, respectively, allows good electrical contact to the waveguide base and the epitaxial region.

In another implementation of the monolithic integrated phase modulator, the epitaxial region has a doping profile that includes a second conductivity type doping level that changes in a direction from the surface of the interface between the epitaxial region and the first conductivity type waveguide base to a further surface of the epitaxial region.

That is, the doping profile of the epitaxial region can be modified during the epitaxial growth of said region, i.e. as the epitaxial growth goes on. The doping profile can be adjusted, in order to improve e.g. the light confinement in the epitaxial region and to maximize modulation efficiency and to minimize losses caused by highly doped semiconductor.

In another implementation of the monolithic integrated phase modulator, a lower second conductivity type doping level near the interface and near the further surface of the epitaxial region, and a higher second conductivity type doping level between the lower second conductivity type doping levels is present.

Since defects are mostly located at the interface and the further surface, the above doping profile is advantageous to maximize the depletion effect and phase modulation in the epitaxial region with lowest detectivity.

A second aspect of the present invention is directed to a method for producing a monolithic integrated phase modulator, the method comprising forming a waveguide for propagating light by: forming a waveguide base from a Si-based semiconductor material and doping the waveguide base to be of a first conductivity type, forming at least one groove in a surface of the waveguide base, and epitaxially growing a region of a second conductivity type III-V semiconductor material on the waveguide base in the groove; wherein the waveguide base and the epitaxial region form a monolithically integrated junction diode that is a phase modulation region for the light propagated through the waveguide.

In an implementation of the method, the forming of the waveguide comprises: forming a plurality of grooves in the surface of the waveguide base arranged one after the other along a light propagation direction of the waveguide, and growing a plurality of epitaxial regions made each of a second conductivity type III-V semiconductor material, wherein an epitaxial region is formed on the waveguide base in each of the grooves; wherein the waveguide base and each of the epitaxial regions form the monolithically integrated junction diode.

The at least one epitaxial layer may be formed by selective area growth.

In another implementation, the method further comprises forming a sidewall region of the waveguide that electrically contacts each epitaxial region, wherein the sidewall region of the waveguide is of the second conductivity type.

The method of the second aspect can have further implementations according to the implementations described for the modulator of the first aspect. The method produces a modulator as described above was the first aspect, and can thus achieve all advantages and effects described above. The method is in particular suitable for high-volume production of modulators.

Notably, the present invention also includes a monolithic integrated phase modulator obtained by the method of the second aspect or any implementation thereof. The method of the second aspect leaves well-determinable fingerprints in the produced monolithic integrated phase modulator, which distinguish it from conventional modulators. In particular, the III-V material, its high material quality (and the resulting carrier mobilities), and the in-situ applied doping profile are well discernable.

A third aspect of the present invention is directed to a method of operating a monolithic integrated phase modulator according to the first aspect or any implementation thereof, the method comprising: propagating light through the waveguide, and reversely biasing the junction diode formed by the waveguide base and the epitaxial region to modulate the phase of the propagated light based on the reverse bias potential.

The modulator can be operated to efficiently modulate the phase of the light, i.e. with the high performance compared to conventional phase modulators

BRIEF DESCRIPTION OF THE DRAWINGS

The above described aspects and implementation forms of the present invention will be explained in the following description of specific embodiments in relation to the enclosed drawings, in which

FIG. 1    shows a waveguide of a monolithic integrated phase modulator according to the invention, wherein the waveguide comprises a monolithically integrated junction diode.

FIG. 2    shows a monolithic phase modulator according to the invention.

FIG. 3    shows another monolithic integrated phase modulator according to the invention.

FIG. 4    shows a carrier density profile in a monolithic integrated phase modulator according to the invention, with and without reverse bias applied to the leads.

FIG. 5 shows (a) a specific carrier density with and without reverse bias, (b) a simulated band diagram vertical cut through the waveguide, and (c) an optical mode profile in the waveguide.

FIG. 6 shows (a) a refractive index profile in the waveguide for a specific carrier density profile, and (b) a change of the refractive index and the absorption coefficient, respectively, with a change of the carrier density.

FIG. 7 shows a bias voltage induced change of (a) the refractive index and (b) a figure of merit of the modulator.

FIG. 8 shows a bias voltage induced change of (a) phase shifter loss in the light modulation region of the monolithic integrated phase modulator and (b) a figure of merit of the modulator.

FIG. 9 shows a conceptional process flow for producing a monolithic integrated phase modulator according to the invention.

DETAILED DESCRIPTION OF EMBODIMENTS OF THE INVENTION

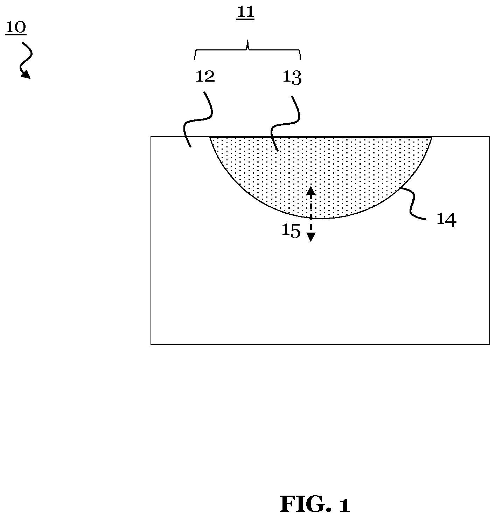

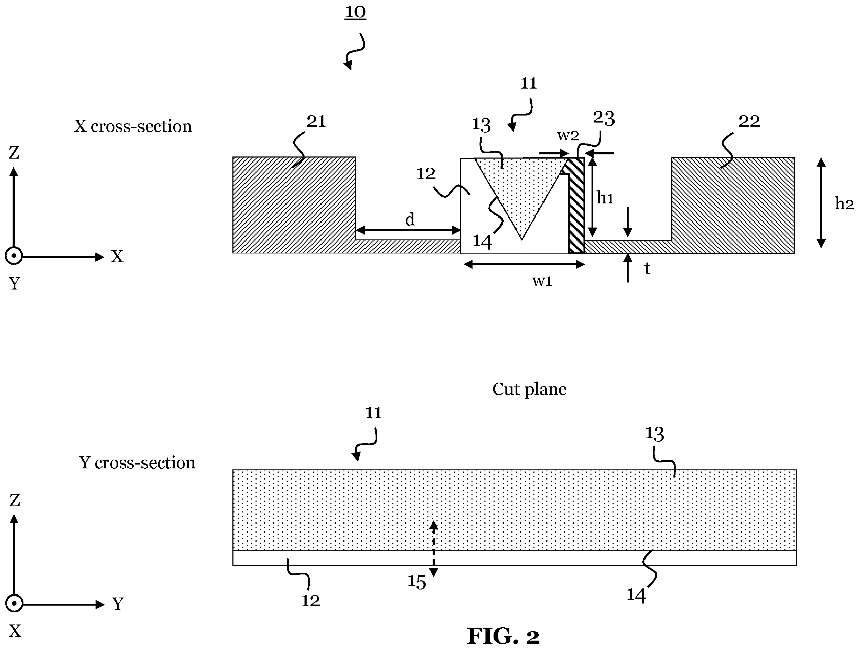

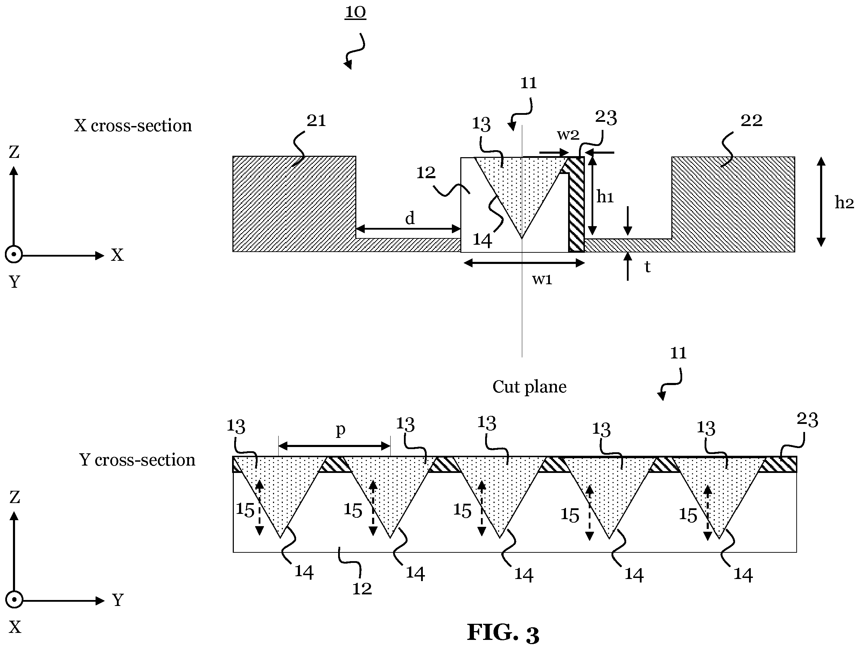

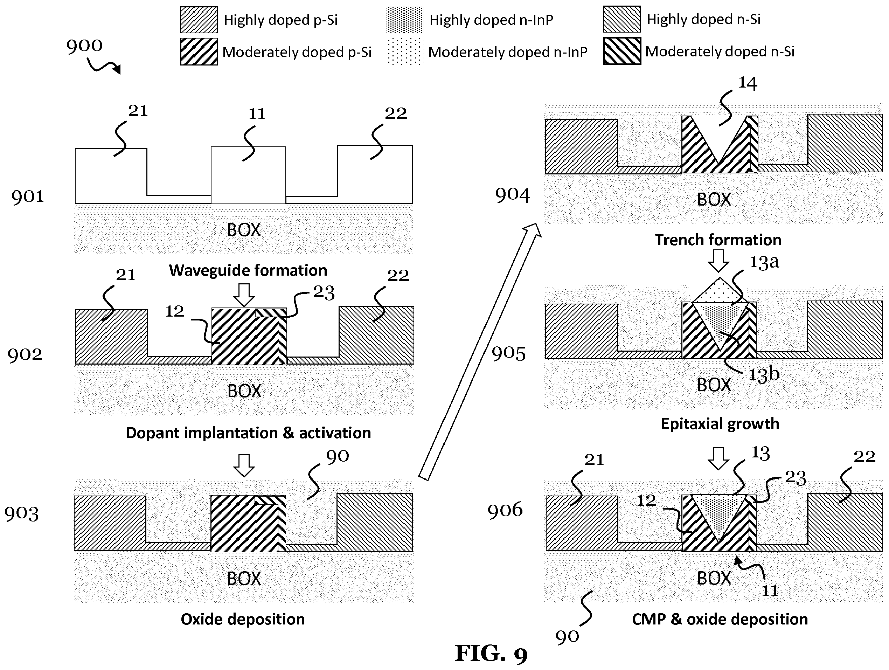

FIG. 1 shows a basic waveguide 11 of a monolithic integrated phase modulator 10 according to the invention. FIG. 1 particularly shows only the waveguide 11, since the waveguide 11 includes the core elements of the invention. The monolithic integrated phase modulator 10 will be explained in more detail with respect to FIG. 2 and FIG. 3. A possible fabrication flow of the modulator 10 will be explained with respect to FIG. 9.

The waveguide 11 of the modulator 10 includes a waveguide base 12 and an epitaxial region 13, which is grown within a groove 14 formed in a surface of the waveguide base 12. The waveguide base 12 is made of a first conductivity type Si-based semiconductor material, for instance, p-type Si and/or SiGe. The epitaxial region 13 is made of a second conductivity type III-V semiconductor material, for instance, n-type InP, GaAs, InGaAs and/or InGaAsP, i.e. the epitaxial region 13 can include either a single- or multi-material stack.

The groove 14 may be a groove fabricated by etching or another trench formation technique. The groove 14 is preferably a V-groove or U-groove (as shown in the example of FIG. 1). The epitaxial region 13 is an epitaxially grown region on the waveguide base 12. The epitaxial region 13 and the waveguide base 12 form a monolithically integrated junction diode 15, particularly a p-n junction diode. This is indicated in FIG. 1 by the double-sided arrow across the (p-n) junction of the junction diode 15, i.e. across the interface between the epitaxial region 13 and the waveguide base 12. The junction diode 15 is monolithically integrated in the waveguide 11, because the waveguide base 12 and the epitaxial layer 13 are monolithically formed on top of each other during preferably one and the same process flow.

The junction diode 15 is arranged to be reversely biased, for instance, by applying a reverse potential to the leads, which contact the waveguide base 12 and the epitaxial region 13, respectively. Possible details of such leads are explained with respect to FIG. 2 and FIG. 3. When the junction diode 15 is biased reversely, depletion regions form in the waveguide base 12 and the epitaxial region 13, particularly starting from the interface. Due to the lower effective mass, depletion regions are stronger in the epitaxial region 13. Because of the change of the electron and hole densities in the junction diode 15, light propagating through the waveguide 11 can be phase modulated based on the above-described effect of plasma dispersion. The III-V epitaxial region 13 makes the phase modulation particularly efficient.

FIG. 2 shows a monolithic integrated phase modulator 10 according to the invention, which includes a waveguide 11 that builds on the basic waveguide 11 shown in FIG. 1. Accordingly, same elements in FIG. 1 and Fig. 2 are labelled with the same reference signs and have likewise functions.

FIG. 2 shows particularly an X cross section (upper drawing) and a Y cross section (lower drawing) of the modulator 10. In the X-Y-Z coordinate system, it is assumed that Z indicates the growth direction of the modulator 10, particularly of the epitaxial region 13, and that Y indicates the light propagation direction through the waveguide 11.

The waveguide 11 of the modulator 10 shown in FIG. 2 includes again the epitaxial region 13 grown in the groove 14 on the waveguide base 12. The groove 14 is in FIG. 2 exemplarily a V-groove. The sidewalls of the V-groove 14 are preferably arranged along (111)-facets of the Si-based waveguide base 12.

As shown in the X cross section, the waveguide 11 further includes a sidewall region 23, which electrically contacts the epitaxial region 13. As can be seen, the sidewall region 23 is a part of the waveguide 11 next to the waveguide base 12 and next to the epitaxial layer 13. The side sidewall region 23 is of the second conductivity type, for instance, with a doping level of between $1 \cdot 10^{17}$ cm-3 and $1 \cdot 10^{19}$ cm-3, particularly $1 \cdot 10^{18}$ cm-3. Notably, at the same time the second conductivity type epitaxial region 13 has a doping level between $1 \cdot 10^{16}$ cm-3 and $5 \cdot 10^{18}$ cm-3, and the first conductivity type Si-based semiconductor material of the waveguide base 12 has a doping level between $1 \cdot 10^{17}$ cm-3 and $1 \cdot 10^{19}$ cm-3, particularly $1 \cdot 10^{18}$ cm-3.

As also shown in the X cross section, the modulator 10 further includes a first lead 21 electrically contacting the waveguide base 12 from the side, i.e. laterally along the X direction. Further, the modulator 10 includes a part of a second lead 22 electrically contacting the sidewall region 23 from the side, i.e. laterally along the X direction. In particular, the sidewall region 23 is also a part of the second lead 22 and electrically contacts the epitaxial region 13. The first lead 21 is of the first conductivity type with a preferred doping level between $1·10^{18}$ cm$^{-3}$ and $1·10^{20}$ cm$^{-3}$, particularly $1·10^{19}$ cm$^{-3}$. The part of the second lead 22 excluding the sidewall region 23 is of the second conductivity type with a preferred doping level between $1·10^{18}$ cm$^{-3}$ and $1·10^{20}$ cm$^{-3}$, particularly $1·10^{19}$ cm$^{-3}$. That is, this part of the second lead 22 may have a higher doping level then the sidewall region 23.

Further, metal contacts may be implemented on the first lead 21 and second lead 22, respectively, in order to interface with the modulator 10. For instance, one end of the first lead 21 may contact the waveguide base 12 and one end of the second lead 22 may contact the epitaxial region 13, while the other end of each lead 21, 22 is contacted by a metal contact. The metal contacts particularly extend to a surface of the modulator 10. The X cross section also shows that the leads 21 and 22 may each include a thicker region (in Z direction) and a thinner region (in Z direction). The thicker regions can be contacted from the outside of the modulator 10, e.g. a connection between the optical modulator 10 and leads in a packaging thereof may be established. The thinner regions contact the waveguide base 12 and sidewall region 23, respectively.

Some dimensions of the modulator 10 are shown in FIG. 2, namely a distance d between the thicker regions and the thinner regions of the leads 21 and 22, a thickness *t* of the thinner regions of the leads 21 and 22, a height *h2* of the thicker regions of the lead 21 or lead 22 and the waveguide 11, a width *w1* of the waveguide 11, a height *h1* between a top surface of the waveguide 11 and a top surface of the thinner regions of the leads 21 and 22, and a width *w2* of the sidewall region 23.

In an example of the modulator 10, *d* = 600-800nm (e.g. 750nm), *t* = 50-100nm (e.g. 70nm), *h2* = 150-300nm (e.g. 220nm), *w1* = 425-525nm (e.g. 475nm), *h1* = 100-200nm (e.g. 150nm), and/or w2 = 25-75nm (e.g. 50nm).

As shown in the Y cross section, the modulator 10 of FIG. 2 includes one epitaxial region 13 in one groove 14 formed in the surface of the waveguide base 12, which groove extends along the light propagation direction of the waveguide 11 (Y direction). The epitaxial region 13 and the waveguide base 12 form accordingly one monolithic integrated junction diode 15, which is the (single) light modulation region of the modulator 10. The modulator 10 of FIG. 2 allows modulating the phase of the light propagating through the waveguide 11 in this light modulation region with high-speed and efficiency.

FIG. 3 shows a monolithic integrated phase modulator 10 according to the invention, which builds on the phase modulator 10 shown in FIG. 2, and includes a waveguide 11 that builds on the basic waveguide 11 shown in FIG. 1. Same elements in FIG. 1, FIG. 2 and FIG. 3 are indicated with the same reference signs and have likewise functions.

FIG. 3 shows, like FIG. 2, an X cross section (upper drawing) and a Y cross section (lower drawing) of the modulator 10. In the X-Y-Z coordinate system, it is again assumed that Z is along the growth direction of the modulator 10, particularly of the epitaxial region 13, and that Y is along the light propagation direction through the waveguide 11.

In contrast to the monolithic integrated phase modulator 10 shown in FIG. 2, the waveguide 11 of the monolithic integrated phase modulator 10 shown in FIG. 3 includes a plurality of grooves 14 and a plurality of epitaxial regions 13, wherein one epitaxial region 13 is formed on the waveguide base 12 in each of the grooves 14.

Since the X cross section shown in FIG. 3 is through one particular epitaxial region 13, it is identical to the X cross section shown in FIG. 2. It can be seen that the monolithic integrated phase modulator 10 shown in FIG. 3 also includes the first lead 21 and the second lead 22 having the sidewall region 23. Conductivity types, doping levels, and dimensions as indicated in the X cross section of the modulator 10 shown in FIG. 3, may be the same as described above with respect to the modulator 10 shown in FIG. 2.

The difference between the modulators 10 shown in FIG. 2 and FIG. 3, respectively, can be seen in the Y cross section. Here, the plurality of grooves 14 formed in the surface of the waveguide base 12, which are arranged one after the other along a light propagation direction of the waveguide 11 (Y direction), and the plurality of epitaxial regions 13 formed in these grooves 14 can be seen. Each epitaxial region 13 forms a monolithically integrated junction diode 15, particularly a p-n junction diode, with the waveguide base 12. It can be seen that each epitaxial region 13 is contacted electrically by the sidewall region 23 of the second lead 22. Thus, a reverse bias can be collectively applied to all junction diodes 15 (accordingly, in this example the diodes 15 may be regarded to be one junction diode 15). It is also be possible to provide separate sidewall regions 23, and thus separate second leads 22, wherein each second lead 22 contacts one epitaxial region or a subset of epitaxial regions 13. Thus, junction diodes 15 could be (reversely) biased independently.

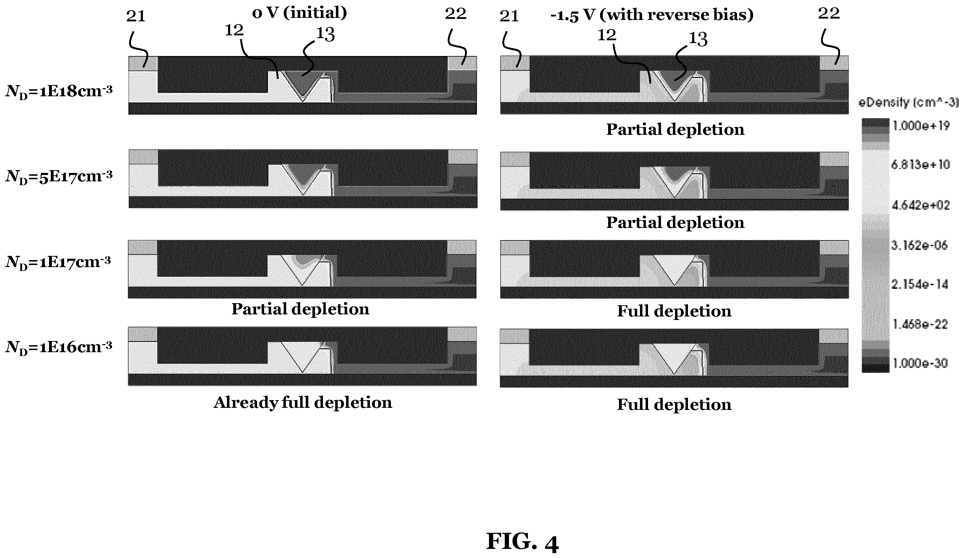

FIG. 4 shows a carrier density profile in a monolithic integrated phase modulator 10 according to the invention, particularly according to the modulator 10 shown in FIG. 1 with an InP epitaxial region 13 and a Si waveguide base 12. The left side of FIG. 4 shows the modulator 10 without reverse bias applied to the leads 21 and 22 (oV), and the right side shows the modulator 10 with a reverse bias applied to the leads 21 and 22 (-1.5V). In particular, the zero bias and reverse bias conditions are shown for four different carrier densities of the epitaxial region 13 of the waveguide 11, namely (from top to bottom) $N_D = 1·10^{18}$ cm$^{-3}$, $5·10^{17}$ cm$^{-3}$, $1·10^{17}$ cm$^{-3}$ and $1·10^{16}$ cm$^{-3}$. The carrier density distribution in the waveguide 11 is shown in grey shading according to the key shown on the rightmost side of FIG. 4.

The carrier profiles are derived by electrical simulations of the modulator 10, in order to demonstrate the concept of the invention. As shown, the reverse bias is able to deplete the InP epitaxial region 13 and the waveguide base 12 in the III-V/Si monolithic junction diode 15, specifically at its III-V/Si interface. This depletion through reverse biasing can modulate the light propagating through the waveguide 11. In particular, FIG. 4 shows that at carrier densities of $N_D = 1 \cdot 10^{18}$ cm$^{-3}$ (in FIG. 4 the notation "1E18 cm$^{-3}$" is used), and $N_D = 5 \cdot 10^{17}$ cm$^{-3}$ and the epitaxial region 13 is not yet depleted at zero bias condition, but depletes partially at reverse bias condition. At a carrier density of $N_D = 1 \cdot 10^{17}$ cm$^{-3}$, the epitaxial region 13 is already partially depleted at zero bias condition, and fully depletes at reverse bias condition. At a carrier density of $N_D = 1 \cdot 10^{16}$ cm$^{-3}$, the epitaxial region 13 is already fully depleted at zero bias condition and thus also at reverse bias condition.

The simulations shown in FIG. 4 are for the exemplary case of InP as the III-V semiconductor material of the epitaxial layer 13, but other III-V semiconductor materials such as GaAs, InGaAs, InGaAsP, etc. can be used likewise.

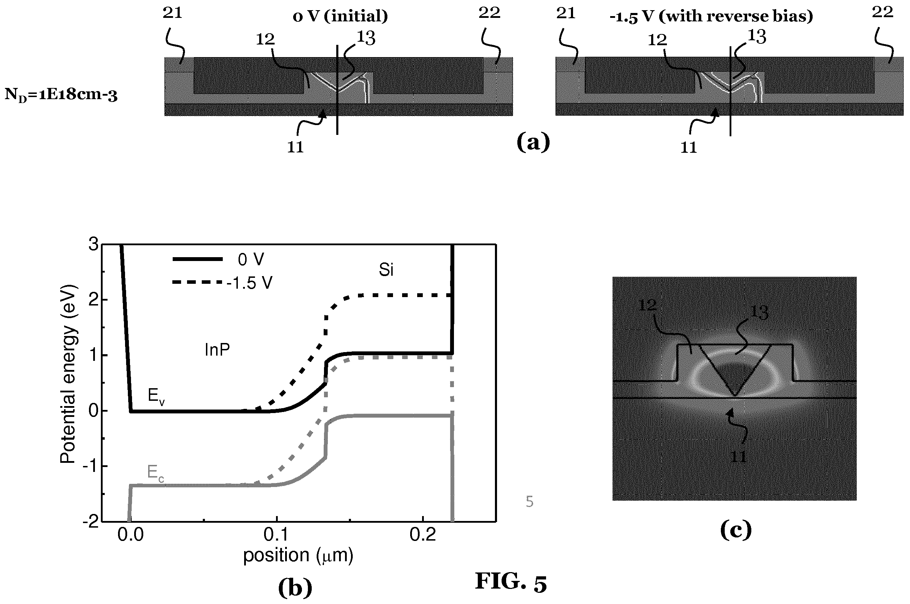

FIG. 5 shows in (a) again a specific carrier density, namely $N_D = 1.10^{18}$ cm$^{-3}$ with and without reverse bias applied. Further, FIG. 5 shows in (b) a band diagram vertical cut simulation at this carrier density through the waveguide 11, as indicated by the vertical lines through the waveguide 11 in (a). Again, the epitaxial region 13 of the waveguide 11 is made of InP and the waveguide base 12 of Si. It can be seen that at reverse bias conditions (dashed lines in (b)), the conduction and valence bands of both the InP epitaxial region 13 and the Si waveguide base 12 are pulled upwards (to higher potential energies (eV)), so that depletion regions are formed at least at the InP/Si interface.

FIG. 5 shows further in (c) an optical mode profile of light propagated through the waveguide 11. From the optical mode profile simulation, it can be derived that most of the light is confined in the epitaxial region 13, which is here exemplarily in the form of a V-groove. Thus, most of the light passes through the lower effective mass III-V semiconductor material, where it can be phase modulated more efficiently and with lower optical loss.

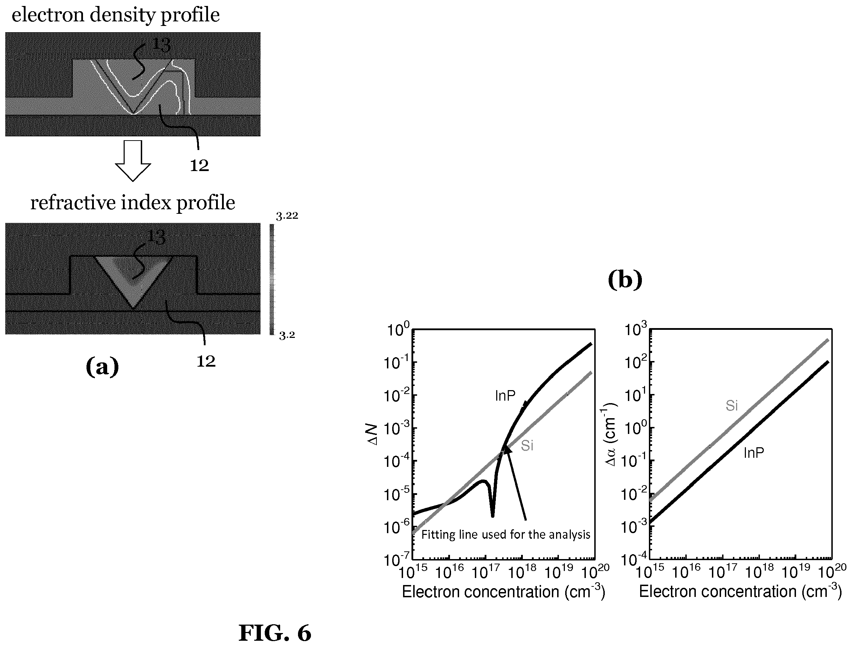

FIG. 6 shows in (a) a carrier density profile in the waveguide 11 at a carrier density of again $N_D = 1 \cdot 10^{18}$ cm$^{-3}$ in the epitaxial region 13. Beneath that, FIG. 6 shows in (a) a refractive index profile for said carrier density profile. It can be seen, how the refractive index is different in the InP epitaxial region 13 and the Si waveguide base 12, respectively, but also how it is different within the epitaxial region 13 in differently depleted/populated areas.

FIG. 6 shows further in (b) a change of the refractive index $\Delta n$ and a change of the absorption coefficient $\Delta \alpha$, respectively, in dependence of a change of the carrier density. $\Delta n$ and $\Delta \alpha$ were calculated considering the plasma dispersion effect, band-filling effects, bandgap shrinkage effects, and inter-valence band absorption. It can be seen that the refractive index change in the InP material is much steeper in the region between carrier densities of $1 \cdot 10^{17}$ cm$^{-3}$ and $1 \cdot 10^{18}$ cm$^{-3}$, where the refractive index change can be linearly fitted, than for the Si material. Due to this more rapid change of the refractive index, the modulation performance of the modulator 10 is higher than for a modulator that is made only from a Si-based semiconductor material.

It can further be seen that the absorption coefficient behaves linearly in both semiconductor materials, but is in absolute numbers always lower in the InP epitaxial region 13 than in the Si waveguide base 12. This is due to the higher mobility of the epitaxially grown III-V semiconductor material. This effect more than compensates the influence of the lower effective mass of this III-V semiconductor material (compared to the Si in the waveguide base 12) to the absorption coefficient.

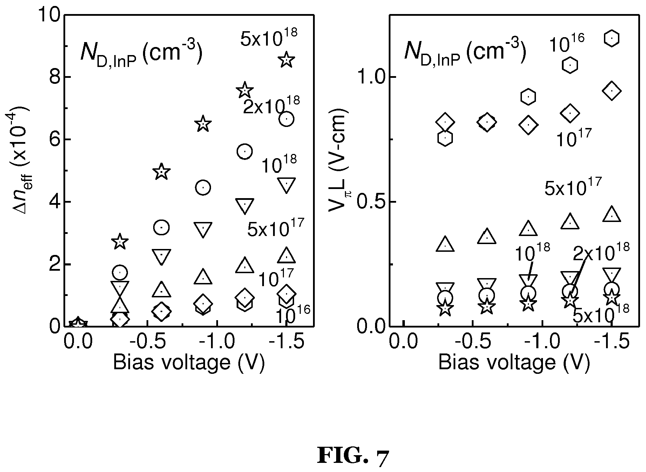

FIG. 7 shows (on the left hand side) changes in the effective refractive index $\Delta n_{eff}$ for different bias condition and different carrier densities, calculated by overlapping the optical mode with the carrier distribution. FIG. 7 shows further (on the right hand side) changes of $V_\pi L$, which is a measure of the voltage $V_\pi$ per length L in cm, which is required to effect a $\pi$ phase shift of the light propagating through the waveguide 11. Thus, it is a figure-of-merit of the modulator 10.

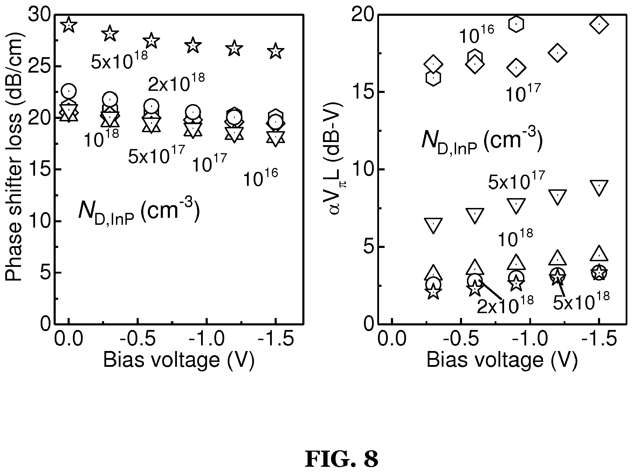

FIG. 8 shows a likewise calculated phase shifter loss (left hand side) and $\alpha V_\pi L$ (right hand side), the latter being a product of the absorption coefficient and $V_\pi L$, and thus another representative figure-of-merit of the modulator 10.

FIG. 7 and FIG. 8 and demonstrate the effective modulation characteristics, which can be obtained with the modulator 10 of the invention, owing to the small effective mass in the III-V semiconductor material of the epitaxial region 13. Notably, the obtained representative figure-of-merit $\alpha V \pi L$ is impressively low compared to a conventional Si-based optical modulator (several tens of dB-V).

The monolithic integrated phase modulator 10 of the invention can be generally produced with the method that forms the waveguide 11 by: forming a waveguide base 12 from a Si-based semiconductor material and doping the waveguide base 12 to be of a first conductivity type; then forming at least one groove 14 in a surface of the waveguide base 12 and epitaxially growing a region 13 of a second conductivity type III-V semiconductor material on the waveguide base 12 in the groove 14, particularly an epitaxial region 13 in each groove 14, if there are multiple grooves in the waveguide base 12 surface. Accordingly, the general production method can produce the modulator 10 with one epitaxial region 13 shown in FIG. 2 and the modulator 10 with multiple epitaxial regions 13 shown in FIG. 3.

FIG. 9 shows a specific example of a process flow 900 for such a production method. The at least one III-V semiconductor material may be grown in the groove by SAG.

In particular, in a step 901, the region that will later be the waveguide 11 (shown generally in FIG. 1) is formed, for instance, by etching Si-based semiconductor material, e.g. p-Si. Likewise, the regions that would later be the leads 21 and 22 may be formed in this way.

In step 902, dopants were implanted into the Si-based semiconductor material and activation is done. In particular, as indicated by the different shadings, the leads 21 and 22 can be formed by doping them to be highly-doped p-Si (lead 21) and highly-doped n-Si (lead 22), respectively. Further, the waveguide 11 region can be doped to form the sidewall region 23 to be moderately doped n-Si. The remainder of the waveguide region 11 (i.e. the waveguide base 12) can be doped to be a moderately doped p-Si region. Particularly, the doping of the waveguide base 12 and the sidewall region 23, respectively, may be selected high enough to make it electrically low resistive, but at the same time low enough to minimize optical losses.

In step 903 an oxide 90 can be deposited over the semi-finished modulator structure. The oxide 90 may for instance be $SiO_2$.

In step 904 at least one groove 14 is formed by a trench formation technique like dry and/or wet etching. The groove 14 shown in FIG. 9 is exemplarily of a V-shape. However, it may also have a U-shape or other suitable shape.

In step 905, the III-V semiconductor material of the second conductivity type (here exemplarily n-type InP) is grown into the at least one groove 14 on the groove surfaces. The growth is an epitaxial growth, and forms the epitaxial region 13. The second conductivity type doping of the epitaxial region 13 can be performed in-situ, and the doping level and profile can be controlled. The doping profile may change in a direction from the surface of the interface between the epitaxial region 13 and the n-type Si to a further surface of the epitaxial region 13. In particular, as schematically shown in FIG. 9, moderately doped n-InP and highly doped n-InP may be grown in the epitaxial region 13.

Due to a potential impact of defect density near the III-V/Si interface, to avoid/mitigate this impact, a doping profile (low-high-low) may be designed from the interface to top surface of the epitaxial layer 13. In other words, as shown in FIG. 9 in steps 905 and 906, moderately doped n-InP 13a could be grown near the interface and near the top surface of the epitaxial region 13, and highly doped n-InP 13b may be grown between the moderately doped regions. Such a design can be optimized to maximize the depletion in high-quality regions in III-V semiconductor material of the epitaxial region 13, not near the III-V/Si interface.

In step 906, chemical-mechanical planarization (CMP) can be performed of the III-V semiconductor material in particular, and a final protective oxide deposition can be applied.

In contrast to the process flow 900 shown in Fig. 9, so far reported III-V/insulator/Si modulator structures all use wafer bonding to fabricate the structure, which makes the process not fully Si-compatible. Here, III-V semiconductor material growth using SAG can be used for high film quality in the epitaxial region 13. The process flow 900 of FIG. 9 is simple and it can be implemented in large Si wafer (300 mm and even larger).

In summary, the present invention presents an improved monolithic integrated phase modulator 10, particular in terms of modulation efficiency and loss performance, and an improved high-volume production method.

## Claims

1. Monolithic integrated phase modulator (10) comprising
   a waveguide (11) for propagating light, wherein the waveguide (11) includes

   - a waveguide base (12) made of a first conductivity type Si-based semiconductor material,
   - at least one groove (14) formed in a surface of the waveguide base,
   - an epitaxial region (13) formed on the waveguide base (12) in the groove (14), wherein the epitaxial region (13) is made of a second conductivity type III-V semiconductor material, and

   wherein the waveguide base (12) and the epitaxial region (13) form a monolithically integrated junction diode (15) that is a phase modulation region for the light propagated through the waveguide (11).

2. Monolithic integrated phase modulator (10) according to claim 1, wherein
   the waveguide (11) includes

   - a plurality of grooves (14) formed in the surface of the waveguide base (12) and arranged one after the other along a light propagation direction of the waveguide (11), and
   - a plurality of epitaxial regions (13) made each of a second conductivity type III-V semiconductor material,
   - wherein an epitaxial region (13) is formed on the waveguide base in each of the grooves (14), and

   wherein the waveguide base (12) and each of the epitaxial regions (13) form the monolithically integrated junction diode (15).

3. Monolithic integrated phase modulator (10) according to claim 2, wherein
   each epitaxial region (13) together with the waveguide base (12) is a separate phase modulation region for the light propagated through the waveguide (11).

4. Monolithic integrated phase modulator (10) according to claim 2 or 3, wherein adjacent grooves (14) are distanced by a subwavelength pitch.

5. Monolithic phase modulator (10) according to any one of the claims 1 to 4, wherein each epitaxial region (13) is arranged to guide at least a part of light that is propagated in the waveguide (11).

6. Monolithic integrated phase modulator (10) according to any one of the claims 1 to 5, further comprising

   a first lead (21) electrically contacting the waveguide base (12), wherein the first lead (21) is made of a first conductivity type Si-based semiconductor material, and
   a second lead (22) electrically contacting each epitaxial region (13), wherein the second lead (22) is made of a second conductivity type Si-based semiconductor material.

7. Monolithic integrated phase modulator (10) according to claim 6, wherein
   the second lead (22) includes a sidewall region (23) of the waveguide (11) that electrically contacts each epitaxial region (13), and
   the sidewall region (23) of the waveguide (11) of the second lead (22) is of the second conductivity type.

8. Monolithic integrated phase modulator (10) according to claim 6 or 7, wherein
   each epitaxial region (13) and the waveguide base (12) are arranged to be depleted, when the junction diode (15) is reversely biased by applying a reverse potential across the leads (21, 22).

9. Monolithic integrated phase modulator (10) according to any one of the claims 1 to 8, wherein
   the at least one groove (14) is a V-groove or U-groove.

10. Monolithic integrated phase modulator (10) according to any one of the claims 1 to 9, wherein
    at least one sidewall of the at least one groove (14) is arranged along a (111)-facet of the Si-based waveguide base (12).

11. Monolithic integrated phase modulator (10) according to any one of the claims 1 to 10, wherein
    the second conductivity type epitaxial region (13) has a doping level between $1 \cdot 10^{16}$ cm$^{-3}$ and $5 \cdot 10^{18}$ cm$^{-3}$, and/or
    the first conductivity type Si-based semiconductor material has a doping level between $1 \cdot 10^{17}$ cm$^{-3}$ and

$1 \cdot 10^{19}$ cm$^{-3}$, and/or,
when the modulator (10) is according to claim 7, the second conductivity type sidewall region (23) has a doping level between $1 \cdot 10^{17}$ cm$^{-3}$ and $1 \cdot 10^{19}$ cm$^{-3}$.

12. Monolithic integrated phase modulator (10) according to any one of the claims 1 to 11, wherein
    the epitaxial region (13) has a doping profile that includes a second conductivity type doping level that changes in a direction from the surface of the interface between the epitaxial region (13) and the first conductivity type waveguide base (12) to a further surface of the epitaxial region (13).

13. Monolithic integrated phase modulator (10) according to claim 12, wherein the doping profile includes a lower second conductivity type doping level near the interface and near the further surface of the epitaxial region (13), and
    a higher second conductivity type doping level between the lower second conductivity type doping levels.

14. Method for producing a monolithic integrated phase modulator (10), the method comprising
    forming a waveguide (11) for propagating light by

    - forming a waveguide base (12) from a Si-based semiconductor material and doping the waveguide base (12) to be of a first conductivity type,
    - forming at least one groove (14) in a surface of the waveguide base (12), and
    - epitaxially growing a region (13) of a second conductivity type III-V semiconductor material on the waveguide base (12) in the groove (14),

    wherein the waveguide base (12) and the epitaxial region (13) form a monolithically integrated junction diode (15) that is a phase modulation region for the light propagated through the waveguide (11).

15. Method of operating a monolithic integrated phase modulator (10) according to any one of the claims 1 to 13, the method comprising
    propagating light through the waveguide (11),
    reversely biasing the junction diode (15) formed by the waveguide base (12) and the epitaxial region (13) to modulate the phase of the propagated light based on the reverse bias potential.

EP 3 581 993 A1

10

11

12    13

14

15

**FIG. 1**

FIG. 2

EP 3 581 993 A1

X cross-section

Y cross-section

Cut plane

**FIG. 3**

FIG. 4

**FIG. 5**

EP 3 581 993 A1

FIG. 6

**FIG. 7**

EP 3 581 993 A1

FIG. 8

FIG. 9

Europäisches
Patentamt

European
Patent Office

Office européen
des brevets

# EUROPEAN SEARCH REPORT

Application Number

EP 18 17 6934

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 437 836 A2 (NEC CORP [JP]) 24 July 1991 (1991-07-24) * column 4, line 49 - line 52 * * column 5, line 52 - column 6, line 31; figure 1 * * column 7, line 13 - line 34 * ----- | 1 | INV. G02F1/025 G02F1/015 |
| X | REED G T ET AL: "Tailoring the Response of Silicon Photonics Devices", LEOS 2006 : 19TH ANNUAL MEETING OF THE IEEE LASERS AND ELECTRO-OPTICS SOCIETY, 2006 ; OCT. 29, 2006 - NOV. 2, 2006, MONTREAL, IEEE, PISCATAWAY, NJ, 1 October 2006 (2006-10-01), pages 316-317, XP031004107, ISBN: 978-0-7803-9556-5 | 1,5-11, 14,15 | |
| Y A | * the whole document * ----- | 2-4 12,13 | |
| X | GARDES F Y ET AL: "Optical modulators in silicon photonic circuits", 28 January 2005 (2005-01-28), SILICON PHOTONICS : THE STATE OF THE, CHICHESTER [U.A.] : WILEY, US, PAGE(S) 95 - 145, VII, XP008144395, ISBN: 0-470-02579-4 | 1,5-11, 14,15 | TECHNICAL FIELDS SEARCHED (IPC) G02F G02B |
| Y A | * page 31 - page 32; figure 4.31 * * page 37 - page 40; figure 4.42 to 4.47 * * page 32 * ----- | 2-4 12,13 | |
| Y | EP 0 938 643 A1 (BOOKHAM TECHNOLOGY LTD [GB]) 1 September 1999 (1999-09-01) * figure 1 * ----- | 2,3 | |
| Y | US 7 133 577 B1 (BRATKOVSKI ALEXANDRE M [US] ET AL) 7 November 2006 (2006-11-07) * page 40 * ----- | 4 | |

The present search report has been drawn up for all claims

| Place of search | Date of completion of the search | Examiner |
|---|---|---|
| The Hague | 19 October 2018 | Ladiray, Olivier |

## ANNEX TO THE EUROPEAN SEARCH REPORT
## ON EUROPEAN PATENT APPLICATION NO.

EP 18 17 6934

This annex lists the patent family members relating to the patent documents cited in the above-mentioned European search report.
The members are as contained in the European Patent Office EDP file on
The European Patent Office is in no way liable for these particulars which are merely given for the purpose of information.

19-10-2018

| Patent document cited in search report | | Publication date | Patent family member(s) | | Publication date |
|---|---|---|---|---|---|
| EP 0437836 | A2 | 24-07-1991 | DE | 69019498 D1 | 22-06-1995 |
| | | | DE | 69019498 T2 | 29-02-1996 |
| | | | EP | 0437836 A2 | 24-07-1991 |
| | | | US | 5825047 A | 20-10-1998 |
| EP 0938643 | A1 | 01-09-1999 | AU | 722535 B2 | 03-08-2000 |
| | | | CA | 2269828 A1 | 28-05-1998 |
| | | | CN | 1238041 A | 08-12-1999 |
| | | | DE | 69713375 D1 | 18-07-2002 |
| | | | DE | 69713375 T2 | 27-03-2003 |
| | | | EP | 0938643 A1 | 01-09-1999 |
| | | | GB | 2319335 A | 20-05-1998 |
| | | | JP | 2001508173 A | 19-06-2001 |
| | | | KR | 20000053301 A | 25-08-2000 |
| | | | WO | 9822775 A1 | 28-05-1998 |
| US 7133577 | B1 | 07-11-2006 | NONE | | |

EPO FORM P0459

For more details about this annex : see Official Journal of the European Patent Office, No. 12/82